# EUROPEAN PATENT SPECIFICATION

(11) **EP 2 881 429 B1**
(45) Date of publication and mention of the grant of the patent: **25.01.2017**
(21) Application number: 13825815.7
(22) Date of filing: 01.08.2013
(51) Int. Cl.: C08L 27/12, C08K 9/02, C08K 9/06, H01L 31/042

(54) **RESIN FILM, BACKSHEET FOR SOLAR CELL MODULE, AND SOLAR CELL MODULE**
HARZFOLIE, RÜCKSEITIGE FOLIE FÜR EIN SOLARZELLENMODUL UND SOLARZELLENMODUL
FILM DE RÉSINE, FEUILLE DE SUPPORT POUR MODULE DE CELLULES SOLAIRES, ET MODULE DE CELLULES SOLAIRES

(30) Priority: 02.08.2012 JP 2012172067
(43) Date of publication of application: 10.06.2015
(73) Proprietor: Asahi Glass Company, Limited, Tokyo 100-8405 (JP)
(72) Inventor: ARUGA, Hiroshi, Tokyo 100-8405 (JP)
(74) Representative: Müller-Boré & Partner Patentanwälte PartG mbB
(86) International application number: PCT/JP2013/070928
(87) International publication number: WO 2014/021436

(56) References cited:
- EP-A1- 2 460 845
- WO-A1-03/083008
- WO-A1-2011/013576
- JP-A- H08 259 731
- JP-A- H11 279 358
- JP-A- 2010 143 948
- JP-A- 2011 157 492

## Description

### TECHNICAL FIELD

The present invention relates to a resin film useful for a backsheet for a solar cell module, a backsheet provided with the resin film and a solar cell module provided with the backsheet.

### BACKGROUND ART

A solar cell is a semipermanent and pollution-free energy source which employs sunlight, whereas fossil fuel increases carbon dioxide in the air and greatly deteriorates the global environment. Accordingly, development of various solar cells as an important energy source in future is attempted.

A solar cell is commonly used as a solar cell module having a solar cell element sealed by EVA (ethylene/vinyl acetate copolymer) and its front surface and rear surface sandwiched between a transparent glass substrate and a backsheet (rear side laminate).

A backsheet is provided to protect the EVA and the solar cell element, and it is thereby required to have a strength. Further, since a solar cell module is exposed to the outside for a long period of time, the outermost film of the backsheet is required to have sufficient weather resistance. Accordingly, as a backsheet, a PET film excellent in strength is used alone, or in order to suppress hydrolysis or light deterioration of the PET film, a use of a PET film laminated with a resin film excellent in weather resistance as the outermost film, is used in many cases.

A fluororesin film using a fluororesin such as ETFE (ethylene/tetrafluoroethylene copolymer), PVF (polyvinyl fluoride) or PVdF (polyvinylidene fluoride) has been known as a resin film excellent in weather resistance. Among them, an ETFE film and a PVdF film are excellent in moisture resistance in that they are completely free from a decrease in the strength by hydrolysis even when a test at 85°C under a relative humidity of 85% is carried out for 1,000 hours. Further, an ETFE film is also excellent in heat resistance in that the temperature at which the elongation is decreased by half by a heat resistance test for 100,000 hours is from about 150 to about 160°C. Accordingly, such a resin film, especially an ETFE film is useful for a backsheet, especially as an outermost film of a backsheet.

The backsheet is required to have a moisture-proof property for suppressing water vapor permeation and thereby protecting a solar cell element from water vapor, but the water vapor permeation cannot sufficiently be suppressed only with a fluororesin film (outermost film). Accordingly, a method of laminating an aluminum foil or a moisture-proof plastic sheet on a fluororesin film to prevent water vapor from entering the solar cell module is employed in many cases. In such a case, with a view to protecting the plastic sheet and an adhesive to be used for lamination from sunlight, the fluororesin film is required to have an ultraviolet shielding function. Specifically, the fluororesin film is required to have an ultraviolet transmittance at a wavelength of at most 360 nm of less than 0.03%.

As a method for imparting ultraviolet shielding function to a resin film, a method of dispersing an ultraviolet shielding agent to a resin film may be mentioned. As an ultraviolet shielding agent, titanium oxide is used in many cases.

However, since titanium oxide shows high catalytic activity by light or heat, the heat resistance and the light resistance are deteriorated when titanium oxide is blended as it is with a resin film. For example, deterioration of a resin or discoloration of a film occurs due to e.g. heat at the time of film formation or light on the resin film.

Accordingly, in order to suppress catalytic activity, the surface of titanium oxide is covered with silicon oxide (e.g. Patent Document 1).

However, in order to sufficiently suppress catalytic activity of titanium oxide, it is necessary to cover it with a large amount of silicon oxide. When titanium oxide is covered with a large amount of silicon oxide, light resistance is improved, but water of crystallization contained in silicon oxide is vaporized at the time of film formation, whereby defects such as bubble streaks tend to form.

In order to solve such problems, Patent Document 2 proposes, as a titanium dioxide pigment for a plastic resin composition which is excellent in the dispersibility, light resistance and weather resistance and which hardly causes surface defects, one having a compact hydrated silica cover layer on the surface of a titanium oxide particle and having an organic compound cover layer on the cover layer.

### PRIOR ART DOCUMENTS

### PATENT DOCUMENTS

Patent Document 1: JP-A-8-259731
Patent Document 2: JP-A-2006-37090

### DISCLOSURE OF INVENTION

### TECHNICAL PROBLEM

In recent years, a solar cell module has been required to have further improved durability. Further, the solar cell module is less likely to be installed in roof-integrated system, and is instead installed independently in an installation site such as a roof, in many cases. Especially, it is often installed on the slant at an optimum angle so that the transparent glass substrate faces the sun depending on the latitude at the installation site. In such an installation method, a large quantity of reflected light of sunlight is applied to the backsheet at the rear side of the solar cell module. Therefore, the outermost film of the backsheet is also required to have more excellent weather resistance (such as light resistance and heat resistance).

Specifically, in a weather resistance test (the exposure by SWM for from 250 to 500 hours corresponds to the outdoor exposure for one year) by a carbon arc sunshine weather meter (SWM), the film was heretofore required to have an weather resistance to such an extent that at least 50% of initial breaking strength is retained after the exposure for 5,000 hours (corresponding to the outdoor exposure for 10 to 20 years). However, in recent years, it has been required to sufficiently retain optical properties such as solar reflectance or ultraviolet shielding performance, or mechanical properties such as breaking strength (for example, at least 80% of initial breaking strength is retained), even after the exposure for 10,000 hours by SWM. Further, the evaluation time of the test at 85°C under a relative humidity of 85% for observing the extent of hydrolysis has been conventionally 1,000 hours, but is 3,000 hours in recent years.

Further, the thickness of a fluororesin film to be used for the outermost film has been conventionally about 25 µm, but in recent years, it has been required to make it thinner, for example, 20 µm or 15 µm, in order to reduce costs. However, if a fluororesin film having titanium oxide particles dispersed so as to impart ultraviolet shielding performance is merely made to be thinner, the ultraviolet shielding performance is deteriorated. Further, due to light irradiation, titanium oxide particles will move to the vicinity of a film surface layer with time, whereby the solar reflectance of the film tends to change or the film tends to be whitened.

Accordingly, the outermost film of the backsheet is required to be a fluororesin film showing excellent ultraviolet shielding performance even when the film is made to be a thin film having a thickness of at most 20 µm, further having excellent weather resistance and being less likely to change in optical properties or mechanical properties for a long period of time.

In a conventional technique, a fluororesin film fully satisfying the above requirements has not been obtained.

For example, the film disclosed in Patent Document 1 is for agricultural greenhouses, membrane structures, etc., and is a film having a thickness of approximately from 100 to 250 µm so as to have translucency or transparency as to transmit at least 40% of visible rays and to have a sufficient strength, and the concentration of titanium oxide contained in the film is less than 5 mass%. On the other hand, the outermost film of the backsheet is required to have the weather resistance and ultraviolet shielding property equal to or higher than those for a film for agricultural greenhouses, etc., and further, as mentioned above, it is required to be so thin as at most 20 µm. Accordingly, in a case where the film disclosed in Patent Document 1 is used as the outermost film of the backsheet, it is necessary to disperse titanium oxide in a larger amount per unit volume, so as to impart ultraviolet shielding property (an ultraviolet transmittance at a wavelength of at most 360 nm being less than 0.03%) which is required for the outermost film of the backsheet. However, if titanium oxide in a large amount necessary for imparting ultraviolet shielding property required is covered with silicon oxide in a large amount for suppressing its catalytic activity, bubble streaks are likely to form by bubbling of water contained in silicon oxide, whereby the film tends to be defective. If such a covering amount is reduced to solve the problem, a covering effect tends to be insufficient, whereby a resin tends to be deteriorated, or the mechanical properties tend to be decreased along with the deterioration.

Further, it has been studied that the titanium dioxide pigment disclosed in Patent Document 2 is dispersed in a fluororesin film, but also in such a case, it is impossible to obtain a fluororesin film fully satisfying the above requirements. For example, in order to impart ultraviolet shielding property capable of cutting at least 99.97% of ultraviolet lays having a wavelength of at most 360 nm, with a film thickness of 20 µm, by using e.g. a titanium dioxide pigment having a silicon oxide content of at least 3%, it is necessary to incorporate the titanium dioxide pigment in a content of about 10% or higher. However, if such a large amount of the pigment is incorporated, bubble streaks tend to form at the time of film formation, even with the titanium dioxide pigment disclosed in Patent Document 2, whereby the film tends to be defective. In a case where a titanium dioxide pigment having a silicon oxide content of less than 3% is used, the amount of addition can be reduced, but the covering effect tends to be insufficient, whereby a resin tends to be deteriorated, and the mechanical properties tend to be decreased along with the deterioration. Further, there is also a problem that continuous production cannot be performed over a period of 10 hours or more. If the continuous production cannot be performed, a production cost tends to increase, and the price of a film thereby tends to increase.

The present invention has been made under these circumstances, and it is an object of the present invention to provide a resin film having excellent ultraviolet shielding properties, further having excellent weather resistance, being hardly changeable in optical properties and mechanical properties for a long time, and being capable of being formed into a thin film of at most 20 µm; a backsheet provided with the resin film; and a solar cell module provided with the backsheet.

### SOLUTION TO PROBLEM

The present invention provides the following.
[1] A resin film comprising a resin (A) containing a fluororesin; and, contained in the resin (A), composite particles (B) each having a cover layer containing at least aluminum oxide on the surface of a titanium oxide particle, and composite particles (C) each having a cover layer containing at least silicon oxide on the surface of a zinc oxide particle, wherein
   in the resin (A), the proportion of the fluororesin is at least 50 mass%,
   in the composite particles (B), the proportion of aluminum oxide is from 0.6 to 2.5 mass%, and the proportion of titanium oxide is at least 95 mass%,
   the content of the composite particles (B) is from 2 to 15 mass% to the resin (A),
   in the composite particles (C), the mass ratio (ZnO/SiO₂ of zinc oxide to silicon oxide is from 50/50 to 85/15, and the total amount of zinc oxide and silicon oxide is at least 80 mass%, and
   the content of the composite particles (C) to the fluororesin is from 0.05 to 0.5 mass%.
[2] The resin film according to [1], wherein the fluororesin is an ethylene/tetrafluoroethylene copolymer.
[3] The resin film according to [1] or [2], wherein the resin (A) is an ethylene/tetrafluoroethylene copolymer.
[4] The resin film according to any one of [1] to [3], which is used for a backsheet for a solar cell module.
[5] A backsheet for a solar cell module, which is provided with the resin film as defined in any one of [1] to [3].
[6] A solar cell module provided with the backsheet as defined in [5].

### ADVANTAGEOUS EFFECTS OF INVENTION

According to the present invention, it is possible to provide a resin film having excellent ultraviolet shielding properties, further having excellent weather resistance, being hardly changeable in optical properties and mechanical properties over a long period of time, and being capable of being formed into a thin film of at most 20 µm; a backsheet provided with the resin film; and a solar cell module provided with the backsheet.

### BRIEF DESCRIPTION OF DRAWINGS

Fig. 1 is a schematic cross-sectional view illustrating one embodiment of the backsheet for a solar cell module.
Fig. 2 is a schematic cross-sectional view illustrating another embodiment of the backsheet for a solar cell module.

### DESCRIPTION OF EMBODIMENTS

### <Resin film>

The resin film according to a first embodiment of the present invention is a resin film comprising a resin (A) containing a fluororesin; and, contained in the resin (A), composite particles (B) each having a cover layer containing at least aluminum oxide on the surface of a titanium oxide particle, and composite particles (C) each having a cover layer containing at least silicon oxide on the surface of a zinc oxide particle, wherein
in the resin (A), the proportion of the fluororesin is at least 50 mass%,
in the composite particles (B), the proportion of aluminum oxide is from 0.6 to 2.5 mass%, and the proportion of titanium oxide is at least 95 mass%,
the content of the composite particles (B) is from 2 to 15 mass% to the resin (A),
in the composite particles (C), the mass ratio (ZnO/SiO₂) of zinc oxide to silicon oxide is from 50/50 to 85/15, and the total amount of zinc oxide and silicon oxide is at least 80 mass%, and
the content of the composite particles (C) to the fluororesin is from 0.05 to 0.5 mass%.

### [Resin (A)]

The resin (A) contains at least a fluororesin.

The fluororesin may, for example, be an ethylene/tetrafluoroethylene copolymer, a vinyl fluoride polymer, a vinylidene fluoride polymer, a vinylidene fluoride/hexafluoropropylene copolymer, a tetrafluoroethylene/hexafluoropropylene/vinylidene fluoride copolymer, a tetrafluoroethylene/propylene copolymer, a tetrafluoroethylene/vinylidene fluoride/propylene copolymer, a hexafluoropropylene/tetrafluoroethylene copolymer or a perfluoro(alkyl vinyl ether)/tetrafluoroethylene copolymer. The fluororesin may be one type or a mixture of two or more types.

Among them, the fluororesin is preferably an ethylene/tetrafluoroethylene copolymer (hereinafter, referred to as ETFE). ETFE is excellent in e.g. weather resistance or heat resistance, among the above fluororesins.

### (ETFE)

ETFE is a copolymer having structural units based on tetrafluoroethylene (hereinafter, referred to as TFE units) and structural units based on ethylene (hereinafter, referred to as ethylene units).

In the ethylene/tetrafluoroethylene copolymer, the molar ratio (TFE units/ethylene units) of TFE units to ethylene units is preferably from 20/80 to 80/20, more preferably from 30/70 to 70/30, furthermore preferably from 40/60 to 60/40.

ETFE may contain, in addition to the TFE units and the ethylene units, structural units based on another monomer. However, the proportion of the repeating units based on such another monomer is preferably at most 10 mol%, more preferably at most 6 mol%, furthermore preferably at most 3 mol%, based on the total (100 mol%) of the entire structural units of ETFE.

Such another monomer may, for example, be a fluoroethylene (excluding TFE) such as CF₂=CFCl or CF₂=CH₂; a C₃₋₅ perfluoroolefin such as hexafluoropropylene or octafluorobutene-1; a polyfluoroalkylethylene represented by X(CF₂)ₙCY=CH₂ (wherein X and Y are each independently a hydrogen atom or a fluorine atom, and n is an integer of from 2 to 8); a perfluorovinyl ether such as R^{f}(OCFXCF₂)ₘOCF=CF₂ (wherein R^{f} is a C₁₋₆ perfluoroalkyl group, X is a fluorine atom or a trifluoromethyl group, and m is an integer of from 0 to 5); a perfluorovinyl ether having a group capable of easily converted to a carboxylic acid group or a sulfonic acid group, such as CH₃OC(=O)CF₂CF₂CF₂OCF=CF₂ or FSO₂CF₂CF₂OCF(CF₃)CF₂OCF=CF₂; a perfluorovinyl ether having at least two unsaturated bonds, such as CF₂=CFOCF₂CF=CF₂ or CF₂=CFO(CF₂)₂CF=CF₂; a fluoromonomer having an alicyclic structure such as perfluoro(2,2-dimethyl-1,3-dioxol), 2,2,4-trifluoro-5-trifluoromethoxy-1,3-dioxol or perfluoro(2-methylene-4-methyl-1,3-dioxolane); or an olefin having at least C3, such as a C3 olefin (such as propylene) or a C4 olefin (such as butylene or isobutylene).

Among them, in the polyfluoroalkylethylene represented by X(CF₂)ₙCY=CH₂, n is preferably from 2 to 6, more preferably from 2 to 4. Its specific examples include CF₃CF₂CH=CH₂, CF₃CF₂CF₂CF₂CH=CH₂, CF₃CF₂CF₂CF₂CF=CH₂, CF₂HCF₂CF₂CF=CH₂ and CF₂HCF₂CF₂CF=CH₂.

Specific examples of the perfluorovinyl ether such as R^{f}(OCFXCF₂)ₘOCF=CF₂, include perfluoro(methyl vinyl ether), perfluoro(ethyl vinyl ether), perfluoro(propyl vinyl ether), CF₂=CFOCF₂CF(CF₃)O(CF₂)₂CF₃, CF₂=CFO(CF₂)₃O(CF₂)₂CF₃, CF₂=CFO(CF₂CF(CF₃)O)₂(CF₂)₂CF₃ and CF₂=CFOCF₂CF(CF₃)O(CF₂)₂CF₃.

Another monomer in ETFE is preferably the above polyfluoroalkylethylene, hexafluoropropylene or perfluoro(propyl vinyl ether), more preferably CF₃CF₂CH=CH₂, CF₃(CF₂)₃CH₂=CH, hexafluoropropylene or perfluoro(propyl vinyl ether). Such other monomers may be used alone or in combination of two or more.

The number average molecular weight of ETFE is not particularly limited, and is preferably from 100,000 to 500,000, more preferably from 200,000 to 400,000. When the number average molecular weight of ETFE is at least 100,000, the strength will hardly be decreased in the heat resistance test. Further, when the number average molecular weight of ETFE is at most 500,000, formation of a thin film at a level of at most 20 µm, for example 10 µm, will be easy.

The number average molecular weight of ETFE is a value obtained in accordance with the following procedure. Using a rheometer (DAR100) manufactured by Reologica, a molten dynamic shear modulus is measured to obtain the relation between the frequency (w) and the dynamic modulus. Then, on the basis of a reference (W.H. Tuminello, Macromolecules, 1993, 26, 499-503), a molecular weight is obtained from the frequency by conducting fitting so that the relation between the frequency and the molecular weight M would be 1/ω=CM^{3.4} (C: constant), followed by conversion to a differential molecular weight distribution curve, whereby a number average molecular weight is calculated. Further, GNO (plateau modulus) corresponding to an elastic modulus of the entanglement molecular weight is 3.5x10⁶ dyne/cm².

In a case where the fluororesin contains ETFE, ETFE may be used in combination with other fluororesins. Since an ETFE resin is less compatible with such other fluororesins and further has a high mechanical strength, the proportion of ETFE in the fluororesin is preferably at least 90 mass%, more preferably at least 98 mass%, particularly preferably 100 mass%, per 100 mass% of the entire fluororesin contained in a resin film. That is, it is particularly preferred that the fluororesin is ETFE.

The resin (A) may contain other resins other than the fluororesin.

Such other fluororesins may, for example, be an acryl resin, a polycarbonate resin, a polyethylene resin, a polypropylene resin, a polyethylene terephthalate, a polybutylene terephthalate and nylon.

However, the proportion of the fluororesin in the resin (A) is at least 50 mass%. When the proportion of the fluororesin is 50 mass%, the weather resistance, the chemical resistance and the like will be improved.

The proportion of the fluororesin in the resin (A) is preferably at least 50 mass%, more preferably at least 90 mass%, furthermore preferably at least 98 mass%, particularly preferably 100 mass%. That is, it is particularly preferred that the resin (A) is a fluororesin. Especially, the resin (A) is most preferably ETFE.

### [Composite particle (B)]

The composite particles (B) are particles each having a cover layer containing at least aluminum oxide on the surface of a titanium oxide particle.

The proportion of titanium oxide in the composite particles (B) is at least 95 mass%, preferably at least 95.5 mass%, per 100 mass% of the total mass (total of the titanium oxide particles and the cover layer) of the composite particles (B).

Among influences of the composite particles (B) on ultraviolet shielding properties of the resin film, the purity of titanium oxide is dominant. This purity indicates a proportion of titanium oxide when inorganic components (total of titanium oxide and inorganic matter covering the surface thereof) contained in the composite particles (B) is 100. As the purity of titanium oxide becomes higher, the ultraviolet shielding performances are improved by a small amount of the composite particles (B), whereby the transmittance at a wavelength of at most 360 nm becomes low. When the proportion of titanium oxide is at least 95 mass%, the purity of titanium oxide becomes sufficiently high, whereby an excellent ultraviolet shielding effect is shown even with a low content of the composite particles (B).

The upper limit of the proportion of titanium oxide in the composite particles (B) is not particularly limited so long as the total of the titanium oxide particles and the cover layer is 100 mass%.

The cover layer of the composite particles (B) contains at least aluminum oxide.

By incorporating aluminum oxide in the cover layer, an effect of preventing coagulation of the composite particles (B) with one another and an effect of reducing catalytic activity of titanium oxide are provided.

The proportion of aluminum oxide in the composite particles (B) is from 0.6 to 2.5 mass%, preferably from 1.0 to 2.5 mass%, more preferably from 1.0 to 2.0 mass%, per 100 mass% of the total mass of the composite particles (B).

The resin film of the present invention contains the composite particles (C), and therefore when the proportion of aluminum oxide in the composite particles (B) is at least 0.6 mass%, it is possible to sufficiently suppress deterioration of the fluororesin due to titanium oxide, the decrease of the mechanical strength due to the deterioration and a change in optical activity.

Water of crystallization of silicon oxide is not completely removed unless heated (fired) at a temperature of at least 700°C, whereas water of crystallization of aluminum oxide is removed when heated at approximately 120°C as a usual heating temperature before film formation. Accordingly, when the proportion of aluminum oxide in the composite particles (B) is at most 2.5 mass%, bubble streaks are less likely to occur at the time of film formation, whereby a resin film having good outer appearance can readily be obtained. Further, continuous production for at least 10 hours is easy.

The cover layer of the composite particles (B) may contain other inorganic components other than aluminum oxide. Such other inorganic components may, for example, be phosphorus oxide, sodium oxide, silicon oxide, zirconium oxide and cerium oxide.

Among the inorganic components, silicon oxide has been used for suppressing catalytic activity of titanium oxide, but silicon oxide itself contains water of crystallization. As mentioned above, this water of crystallization is not completely removed unless heated (fired) at a temperature of at least 700°C. The same also applies to zirconium oxide or cerium oxide. Accordingly, if the content of such inorganic components is large, it tends to be difficult to carry out continuous production for at least 10 hours. Accordingly, in the composite particles (B), the total amount of silicon oxide, zirconium oxide and cerium oxide is preferably at most 1.0 mass%, more preferably at most 0.8 mass%, per 100 mass% of the total mass of the composite particles (B).

On the other hand, phosphorus oxide, especially a phosphate ion has an effect of suppressing catalytic activity of titanium oxide, as in the above inorganic component. Further, water of crystallization of phosphorus oxide can be removed by heating at about 120°C, as in the water of crystallization of aluminum oxide. Accordingly, phosphorus oxide may be incorporated in an optional proportion so long as the total content with aluminum hydroxide is within a range of at most 4 mass% (preferably at most 3 mass) per 100 mass% of the total mass of the composite particles (B).

Further, inorganic components (such as titanium oxide (TiO₂), aluminum oxide (Al₂O₃), sodium oxide (Na₂O), silicon oxide (SiO₂), diphosphorus pentoxide (P₂O₅), zirconium oxide (ZrO₂) and zinc oxide (ZnO)) in the composite particles (B) and the composite particles (C), are quantitatively determined by using a press sheet of the composite particles (B) or the composite particles (C) by means of a scanning type X-ray fluorescent spectrometer (such as ZSX Primus II manufactured by Rigaku Corporation).

The cover layer of the composite particles (B) may be a single layer or a multilayer.

In a case where the cover layer of the composite particles (B) contains other inorganic components other than aluminum oxide, the inorganic components may be contained in the same layer as aluminum oxide or another layer.

Among the inorganic components, phosphorus oxide or sodium oxide may be incorporated as impurities in an aluminum oxide layer. In a case where silicon oxide or zirconium oxide is contained, it is preferred that a silicon oxide layer or a zirconium oxide layer is provided separately from the aluminum oxide layer. In such a case, the aluminum oxide layer is preferably provided on the outer side of such another layer (the silicon oxide layer or the zirconium oxide layer).

The cover layer of the composite particles (B) may have a surface treated layer as the outermost surface layer.

The surface treating agent constituting the surface treated layer may, for example, be an antioxidant or a hydrophobizing agent. When an antioxidant is used as the surface treating agent, it is possible to prevent coloration at the time of compounding. When a hydrophobizing agent is used as the surface treating agent, it is possible to suppress coagulation of the composite particles (B) in the resin film.

As the antioxidant, a known antioxidant such as a phosphorus-based antioxidant, a phenol-based antioxidant or a sulfur-based antioxidant may be used.

As the hydrophobizing agent, a silane coupling agent (S1) having an alkyl group or a silicone compound (S2) may, for example, be mentioned.

The silane coupling agent (S1) may, for example, be a trialkoxysilane such as isobutyltrimethoxysilane, hexyltrimethoxysilane or (3,3,3-trifluoropropyl)trimethoxysilane; a silazane such as hexamethyldisilazane, or a chlorosilane such as dimethyldichlorosilane. Among them, isobutyltrimethoxysilane is preferred.

The silicone compound (S2) is an organopolysiloxane having an organic group. The organic group is preferably an alkyl group having at most 4 carbon atoms or a phenyl group.

As the silicone compound (S2), one which is commonly called a silicone oil may be used. The silicone oil may, for example, be a straight silicone oil such as dimethyl silicone oil or phenyl methyl silicone oil; an alkyl-modified silicone oil, an alkyl aralkyl-modified silicone oil or a fluorinated alkyl-modified silicone oil. Among them, dimethyl silicone oil is preferred in view of the cost, and phenyl methyl silicone oil is preferred in view of the heat resistance.

The molecular weight of the silicone oil is preferably at most 1,500. When the molecular weight is at most 1,500, for example, an oxygen functional group of aluminum oxide or silicon oxide in the cover layer of the composite particles (B) is reacted with the silicone oil with high efficiency thereby to form a uniform and dense surface treated layer, whereby more favorable dispersibility can be obtained in the resin (A).

As the silicone compound (S2), commercially available products may be used. As the dimethyl silicone oil, SH200 (tradename) manufactured by Dow Corning Toray Co., Ltd., KF96 (tradename) manufactured by Shin-Etsu Chemical Co., Ltd., and TSF451 (tradename) manufactured by Toshiba Silicones, having various molecular weights (viscosities), may, for example, be mentioned. Further, as the phenyl methyl silicone oil, SH510 (tradename), SH550 (tradename) and SH710 (tradename) manufactured by Dow Corning Toray Co., Ltd. and KF54 (tradename) manufactured by Shin-Etsu Chemical Co., Ltd., may, for example, be mentioned.

The hydrophobizing agent is preferably the silicone compound (S2) among the above. Further, in a case where the silane coupling agent (S1) is used, curing of the resin film is likely to advance when exposed to the outside over a long period of time, as compared with a case where it is not used. Whereas, in a case where the silicone compound (S2) is used, curing of the resin film hardly advances even by exposure to the outside over a long period of time, and the flexibility is likely to be maintained. Although the reason is not clearly understood, the silicone compound is estimated to have an effect of suppressing crystallization of a fluororesin.

In the case of providing a surface treated layer, the proportion of the surface treated layer in the composite particles (B) is preferably from 0.3 to 2.5 mass%, more preferably from 0.5 to 1.5 mass%, based on the total mass of the composite particles (B) before providing the surface treated layer, that is, the total mass of the particles (inorganic particles) comprising inorganic components such as titanium oxide and aluminum oxide. When it is at least 0.3 mass%, an effect of providing the surface treated layer can sufficiently be obtained. If it exceeds 2.5 mass%, a large amount of a thermally decomposed product of the surface treating agent is generated at the time of the film formation and is thereby attached to a die when the heat resistance of the surface treating agent is low, and therefore there is a tendency that lip cleaning is frequently needed.

A method for forming the surface treated layer may, for example, be the following method 1 or 2. However, the method is not limited thereto, and known methods may be available.
1. A so-called wet method wherein inorganic particles are added to a solvent having a surface treating agent dissolved therein, an acid, water or the like is added thereto if necessary thereby to promote a reaction with the inorganic particles, and after completion of the reaction, the solvent is removed by drying, followed by pulverizing to obtain surface-treated inorganic particles.
2. A so-called dry method wherein inorganic particles and a surface treating agent are charged in e.g. a Henschel mixer provided with a temperature adjusting function, and then, stirring/dispersing is carried out at a temperature at which the surface treating agent is formed into a liquid and has fluidity, or higher, thereby to attach the surface treating agent to the surface.

As the composite particles (B), one produced by a known production method may be used, or a commercially available product may be used.

As the commercially available product which may be used as the composite particles (B), Ti-Pure (registered trademark) R-101, R-102, R-103, R-104 and R-350 manufactured by DuPont; RCL-69, TiONA188 manufactured by Millennium Inorganic Chemicals; 2230 and 2233 manufactured by Kronos; CR50 and CR63 manufactured by Ishihara Sangyo Kaisha, Ltd.; and CR470 manufactured by Tronox may, for example, be mentioned. A surface treated layer may further be provided on these commercially available products.

The average particle size of the composite particles (B) is preferably from 0.15 to 0.40 µm, more preferably from 0.17 to 0.30 µm.

If the average particle size of the composite particles (B) is less than 0.15 µm, a catalytic activity is easily exhibited since the specific surface area of the titanium oxide particles becomes large, and therefore there is a tendency that the effect of the present invention cannot sufficiently be obtained. For example, if the content of the composite particles (C) to the fluororesin increases, the effect as an acid acceptor as mentioned below is increased, and the effect of the present invention can be obtained, but since the composite particles (C) are expensive, such is economically inconvenient. If the average particle size of the composite particles (B) exceeds 0.40 µm, the ultraviolet shielding function (ultraviolet transmittance at a wavelength of at most 360 nm: at most 0.03%) being expected to a fluororesin film is not satisfied in many cases.

In this specification, the average particle size is a value obtained in such a manner that particle sizes of 20 particles randomly extracted by an electron microscope are measured and averaged.

The content of the composite particles (B) in the resin film is from 2 to 15 mass%, preferably from 5 to 12 mass%, more preferably from 6 to 11 mass%, to the above resin (A).

When the content of the composite particles (B) is at least 2 mass%, most of the ultraviolet rays are absorbed in the composite particles (B) in the vicinity of the surface layer of the resin film and are blocked out, and thus they hardly enter the interior of the resin film, and accordingly it is likely to prevent the ultraviolet rays from reaching the whole resin film to develop the catalytic activity.

The development of the catalytic activity is observed as a whitening phenomenon in which the surface of the film will be whiter by exposure to the outside or in an accelerated weather resistance test. That is, if the catalytic activity is exhibited by the exposure to the outside or the accelerated weather resistance test, the binding power of the fluororesin will be decreased, whereby the composite particles (B) uniformly dispersed in the film will move to the surface layer (a surface exposed to light and water), the concentration of titanium oxide on the surface layer is increased, and accordingly a decrease in the ultraviolet transmittance and an increase in the solar reflectance are induced. This phenomenon is observed as a whitening phenomenon. For the backsheet of a solar cell module, especially for the outermost film, a low ultraviolet transmittance and a high solar reflectance are preferred, but of a film which undergoes such whitening phenomenon, mechanical strength especially breaking strength is deteriorated, and therefore such a film hardly has a high reliability for a long period of time. Further, in view of e.g. a good outer appearance, the values of the ultraviolet transmittance and the solar reflectance are preferably not changed during use.

When the content of the composite particles (B) is at most 15 mass%, the composite particles (B) are easily dispersed in the resin film. Further, the mechanical strength of the resin film is good.

### [Composite particle (C)]

The composite particles (C) are particles each having a cover layer containing at least silicon oxide on the surface of a zinc oxide particle.

By using the composite particles (B), an ultraviolet shielding performance is obtained, and further a continuous forming exceeding 10 hours is possible, but only a cover layer of the composite particles (B) cannot sufficiently suppress catalytic activity of titanium oxide, and change in optical properties or deterioration in mechanical properties with time tends to occur.

Accordingly, when the composite particles (C) are used in a small amount as compared with the composite particles (B), it is possible to sufficiently suppress the catalytic activity of titanium oxide of the composite particles (B), and it is thereby possible to obtain excellent weather resistance.

It is considered that such an effect is derived from synergistic action of an effect of reducing the quantity of ultraviolet rays applied to the composite particles (B) by the function of the composite particles (C) as an ultraviolet shielding agent and an effect of suppressing chain progress of photodecomposition reaction of a fluororesin due to hydrofluoric acid by the function of the composite particles (C) as an acid acceptor of hydrofluoric acid produced by the photodecomposition of the fluororesin.

The latter function and effect as the acid acceptor will be described with reference to specific examples. A fluororesin such as ETFE is decomposed by a catalytic activity by titanium oxide to form an extremely small amount of hydrofluoric acid. It is highly likely that this hydrofluoric acid is neutralized by the zinc oxide particles in the composite particles (C), whereby the photodecomposition of the fluororesin is retarded, since decomposition of a fluororesin is easily accelerated in the hydrofluoric acid.

What is important here is that the zinc oxide particles are covered with a cover layer containing silicon oxide.

Two types of hydrofluoric acids are present depending upon the production process, and one is formed by thermal history at the time of the film formation, and the other is formed by decomposition of the fluororesin due to catalytic activity exhibited by titanium oxide in the resin film. Most of the hydrofluoric acids produced is the latter one. Since the latter one is a decomposition product of the fluororesin, e.g. mechanical strength of the film tends to be deteriorated.

On the other hand, the performance as the acid acceptor is much higher in zinc oxide not covered with a cover layer. For example, zinc oxide having an average particle size of from 0.2 to 0.5 µm, which is uncovered with silicon oxide, is used as a white pigment, but if such a zinc oxide is blended as an acid acceptor, it is converted to zinc fluoride only by contacting with the hydrofluoric acid produced at the time of the film formation, whereby the effect as the acid acceptor is lost before reducing the catalytic activity of titanium oxide.

Since the composite particles (C) have a cover layer containing silicon oxide, the effect as an acid acceptor is not lost even by a very small amount of hydrofluoric acid produced at the time of the film formation, and it has a function to gradually and efficiently neutralize hydrofluoric acid produced by decomposition of a fluororesin due to catalytic activity of titanium oxide in the course of exposure of the resin film to light.

However, this effect is weak in the case of silicon oxide alone. Accordingly, a mass ratio (ZnO/SiO₂) of zinc oxide to silicon oxide in the composite particles (C) is important.

The mass ratio (ZnO/SiO₂) of zinc oxide to silicon oxide in the composite particles (C) is from 50/50 to 85/15, preferably from 60/40 to 80/20.

When ZnO/SiO₂ is within the above range, an effect of gradually and efficiently neutralizing hydrofluoric acid is exhibited, and thereby excellent weather resistance is obtained. For example, it is possible to obtain a good result in a weather resistance test for 10,000 hours by means of a sunshine weather meter.

On the other hand, if the ratio of silicon oxide is too low, an effect of neutralizing hydrofluoric acid tends to be lost in a short time. Further, if the ratio of silicon oxide is too high, the composite particles (C) tend to be coagulated in the course of reaction, or the composite particles (C) tend to be broken at the time of surface treatment or compounding, whereby uncovered zinc oxide tends to be produced, whereby the effect of neutralizing hydrofluoric acid tends to be lost in a short time.

Further, when the composite particles (C) function as an acid acceptor, silicon oxide and zinc oxide contained in the cover layers are respectively converted to silicon fluoride and zinc fluoride, but since the composite particles (C) are fine particles, they do not so much affect the transmittance of visible light rays or near infrared rays occupying 98% of solar light.

The cover layer of the composite particles (C) may contain other inorganic components other than silicon oxide. Such other inorganic components may, for example, be phosphorus oxide, sodium oxide, aluminum oxide, zirconium oxide and cerium oxide.

Here, the total amount of zinc oxide and silicon oxide in the composite particles (C) is at least 80 mass%, preferably at least 85 mass%. When the total amount is at least 80 mass%, the above effect can sufficiently be exhibited by the composite particles (C) even in a very small amount of from 0.05 to 0.5 mass% to the fluororesin.

The cover layer of the composite particles (C) may be a single layer or a multilayer.

In a case where the cover layer of the composite particles (C) contains such other inorganic components other than silicon oxide, such inorganic components may be contained in the same layer as silicon oxide or a different layer.

Among the inorganic components, phosphorus oxide or sodium oxide may be contained in the silicon oxide layer as impurities. In the case of containing aluminum oxide or zirconium oxide, it is preferred to provide an aluminum oxide layer or a zirconium oxide layer separately from the silicon oxide layer. In such a case, it is preferred that the aluminum oxide layer is provided on the outer side of such another layer (the aluminum oxide layer or the zirconium oxide layer).

The cover layer of the composite particles (C) may have a surface treated layer as the outermost layer.

The surface treating agent constituting the surface treated layer may be one which is the same as one mentioned in the explanation of the above composite particles (B).

In the case of providing a surface treated layer, the proportion of the surface treated layer in the composite particles (C) is preferably from 1 to 5 mass%, more preferably from 1.5 to 4 mass%, based on the total mass of the composite particles (C) before providing the surface treated layer, that is the total mass of particles (inorganic particles) comprising of inorganic components such as zinc oxide and silicon oxide. When it is at least 1 mass%, an effect of providing the surface treated layer can sufficiently be obtained. If it exceeds 5 mass%, a large amount of a thermally decomposed product of the surface treating agent is generated at the time of the film formation and is thereby attached to a die when the heat resistance of the surface treating agent is low, and therefore there is a tendency that lip cleaning is frequently needed.

As the composite particles (C), one which is produced by a known production method may be used, or a commercially available product may be used.

The composite particles (C) may be obtained, for example, by a method of covering zinc oxide particles having a surface area of from 25 to 50 m²/g, with silicon oxide. Such a covering method by silicon oxide may, for example, be a method of employing a sol/gel reaction using an alkoxysilane or a production method (such as JP-A-11-256133) from water glass.

The commercially available product which may be used as the composite particles (C) may, for example, be Maxlight ZS-64 (ZnO/SiO₂=80/20 or ZS-64-D (ZnO/SiO₂=78/22) manufactured by Showa Denko K.K.; FINEX-30W-LP2 (ZnO/SiO₂=77/23 or FINEX-50W-LP2 (ZnO/SiO₂=77/23 manufactured by Sakai Chemical Co., Ltd. or MZ-510HPSX (ZnO/SiO₂=83/17) manufactured by TAYCA Corporation. Such commercial products also include one which is subjected to hydrophobization treatment, and further they may be provided with a surface treated layer.

The content of the composite particles (C) is such a very small amount of from 0.05 to 0.5 mass% to the fluororesin, but in a case where the water content (e.g. water of crystallization of silicon oxide) of the composite particles (C) is high, bubble streaks tend to be formed at the time of film formation even with such a very low content.

Accordingly, as the composite particles (C), it is preferred to use one having an ignition loss within 2% at 500°C.

The average particle size of the composite particles (C) is preferably from 0.1 to 5 µm, more preferably from 0.2 to 2 µm. If the average particle size of the composite particles (C) is at least 5 µm, the film outer appearance is not smooth, and if the average particle size of the composite particles (C) is at most 0.1 µm, a larger amount of an organic surface hydrophobizing agent is needed, and therefore film bubble streaks are likely to be formed.

The content of the composite particles (C) in the resin film is from 0.05 to 0.5 mass%, preferably from 0.1 to 0.3 mass% to the above fluororesin.

When the content of the composite particles (C) is at least 0.05 mass% to the fluororesin, it is possible to sufficiently neutralize hydrofluoric acid produced by decomposition of the fluororesin in the course of exposure of the resin film to light.

When the content of the composite particles (C) is at most 0.5 mass% to the fluororesin, the content of silicon oxide is sufficiently low, and bubble streaks are hardly formed at the time of the film formation, whereby it is possible to easily obtain a resin film having a good outer appearance. Further, continuous production for at least 10 hours is easy.

### [Optional components]

The resin film of the present invention may contain other additives other than the composite particles (B) and (C), as the case requires. Such other additives may, for example, be a copper compound such as copper oxide or copper iodide, a hydrophobizing agent, an antioxidant, a pigment for coloration, mica and an anti-fungus agent.

By incorporating the copper compound among them, the heat resistance of the resin film is improved.

The average particle size of the copper compound is preferably from 1 to 50 µm.

The content of the copper compound in the resin film is preferably from 1 × 10⁻⁴ to 5×10⁻² part by mass (from 1 to 500 ppm), more preferably from 5×10⁻⁴ to 3×10⁻² part by mass (from 5 to 300 ppm), most preferably from 1×10⁻³ to 2×10⁻² part by mass (from 10 to 200 ppm), per 100 parts by mass of the resin (A). When the content of the copper compound is at least 1 ppm, the heat resistance of the fluororesin film will easily be improved. Further, when the content of the copper compound is at most 500 ppm, a decrease in electrical properties such as the insulation resistance of the resin film is likely to be suppressed.

The hydrophobizing agent and the antioxidant may be respectively the same as ones mentioned as the surface treating agent in the explanation of the composite particles (B).

The content of the hydrophobizing agent and the antioxidant in the resin film is preferably from 0.5 to 3 parts by mass, per 100 parts by mass of the total of inorganic particles constituting the composite particles (B) and (C), as a total amount of a hydrophobizing agent and an antioxidant constituting the surface treated layer of the composite particles (B) and (C), and a hydrophobizing agent and an antioxidant (which are mixed together with e.g. a resin, the composite particles (B) and the composite particles (C) at the time of compounding) which are blended separately. When it is at least 0.5 part by mass, coagulation of the composite particles (B) and (C) or coloration of the fluororesin can be prevented. When it is at most 3 parts by mass, it is possible to prevent deterioration of the film outer appearance by the bubble streaks formed in the resin film by the influence of heat decomposition in a case where the heat resistance of the hydrophobizing agent or the antioxidant is low.

The resin film of the present invention may be subjected to surface treatment on the surface (for example, when the resin film is used as an outermost film of a backsheet and another layer is laminated thereon to form the backsheet, the surface on which such another layer is to be laminated). The surface treatment is not particularly limited within a range not to impair the effect of the present invention, but may be properly selected from known surface treating methods. Specifically, plasma treatment or corona discharge treatment may, for example, be mentioned.

The thickness of the resin film of the present invention is preferably from 12 to 300 µm, more preferably from 12 to 20 µm. The thinner the film is, the higher the usefulness of the present invention is. Especially, when the thickness is at most 20 µm, it is possible to reduce the cost, whereby it is possible to provide a low-cost resin film.

The resin film of the present invention can be produced by a known method such as a method of kneading the resin (A), the composite particles (B), the composite particles (C) and other optional components to form a resin composition and forming the resin composition into a film by a known formation method. Further, the surface treatment may be carried out as the case requires.

The resin film of the present invention as explained above has excellent ultraviolet shielding performance and weather resistance since the composite particles (B) and (C) are dispersed in prescribed contents in the resin (A). For example, even in the case of a thin film of at most 20 µm, the ultraviolet shielding performance (for example, the ultraviolet transmittance at a wavelength of at most 360 nm is less than 0.03%) which is required to a backsheet of a solar cell module is exhibited for a long period of time. Further, while titanium oxide is contained in such an amount as to obtain a sufficient ultraviolet shielding effect even when the film is so thin as at most 20 µm, change in solar reflectance or deterioration in mechanical strength hardly occurs.

Accordingly, the resin film of the present invention is useful as a backsheet for a solar cell module. For example, by using the resin film of the present invention as an outermost film of a backsheet, it is possible to stably protect a solar cell module for a long period of time.

However, the use of the resin film of the present invention is not limited thereto, and the resin film may be used for e.g. roofs of buildings such as a roof of a warehouse or working facility in agriculture or livestock and a roof of a stadium, a marking film used for e.g. a signboard, or a surface material for wall papers.

Further, in the resin film of the present invention, the failure (such as bubble streaks) in outer appearance at the time of formation is less likely to occur while titanium oxide and silicon oxide are contained therein. Further, continuous production can be carried out over at least 10 hours, whereby continuous productivity is excellent.

There is a difference between the moisture to be controlled for forming a film having a good outer appearance and a good weather resistance, and the moisture for forming the film with good outer appearance over at least 10 hours, and the latter water content is required to be controlled to a lower level, since some of gas components are attached and accumulated on the lip of a die and thereby interrupt a passage of a resin in a case where even a very small amount of gas is produced upon e.g. volatilization of moisture. In order to avoid such a phenomenon, it is effective to open the opening of the lip of the die so that the gas is more likely to be released, but it is impossible to carry out continuous production exceeding 10 hours. Accordingly, it is necessary to reduce gas components, and these gas components have two types of generation sources. One is mainly a volatile component of water of crystallization accompanying silicon oxide, and the other is a volatile component produced from an organic compound to be used as the surface treating agent.

In the present invention, titanium oxide is covered with aluminum oxide, and the proportion of the cover layer is adjusted to a certain level or lower. Accordingly, even when the composite particles (B) are blended in a large amount, the water content of the composite particles (B) is small, and therefore the amount of gas produced by volatilization of moisture contained in the composite particles (B) is extremely small. The composite particles (C) contain silicon oxide, but the content of the composite particles (C) is very small as compared with the composite particles (B), and therefore the amount of gas produced by volatilization of the water of crystallization accompanying silicon oxide is extremely very small. Further, the proportion of the inorganic components is high in both of the composite particles (B) and (C), and even when a surface treated layer is present, the volatile content from the surface treated layer is extremely small. Thus, since generation of the gas components is low as such, it is considered that continuous production over at least 10 hours can be carried out, and the failure of outer appearance at the time of formation is less likely to occur.

### <Backsheet>

The backsheet for a solar cell module of the present invention is provided with the above resin film of the present invention.

The resin film of the present invention is suitably used as an outermost film of a multilayer structured backsheet.

The constitution of the multilayer structured backsheet may be the same as the constitution of a known backsheet except that the resin film of the present invention is used as the outermost film.

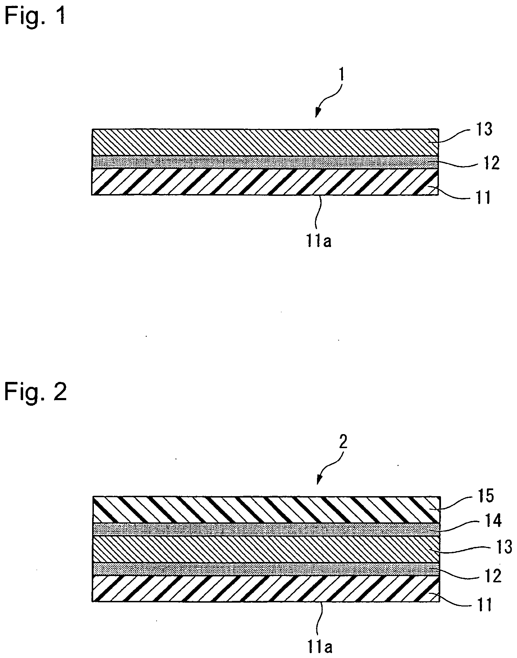

Fig. 1 illustrates one embodiment of the backsheet of the present invention.

The backsheet 1 according to this embodiment is a laminate having an outermost film 11 in contact with air when used for a solar cell module, an adhesive layer 12 and a moisture-proof layer 13 laminated in this order, and the outermost film 11 is the resin film of the present invention.

The moisture-proof layer 13 is a layer for protecting a solar cell element from water vapor by suppressing permeation of the water vapor. The moisture-proof layer 13 is not particularly limited, and may properly be selected from known moisture-proof layers used for a backsheet. As a specific example, a polyethylene terephthalate film having a thin film layer made of a metal oxide such as silicon oxide or aluminum oxide provided by vapor deposition or a sputtering method may be exemplified.

The adhesive layer 12 is not particularly limited so long as it is possible to adhere the outermost film 11 and the moisture-proof layer 13, and it may properly be selected from known adhesives used for adhering a fluororesin film and a moisture-proof layer. For example, one called a two-component curing type urethane-based adhesive may be used.

In the solar cell module, the backsheet 1 is arranged so that the surface 11 a on the outermost film 11 side is in contact with the air.

The backsheet 1 has the resin film of the present invention as an outermost layer and thereby has excellent weather resistance. For example, since the ultraviolet rays entering from the surface 11 a at the outermost film 11 side are shielded, the adhesive layer 12 is hardly deteriorated by the ultraviolet rays, and adhesion between the outermost film 11 and the moisture-proof layer 13 is hardly deteriorated.

Therefore, according to the backsheet 1, the quality of a solar cell module can be maintained over a long period of time as compared with a conventional backsheet.

Further, in a case where the solar cell module is installed on the slant so as to face the sun, a large quantity of reflected light of sunlight is applied to the backsheet at the rear side of the solar cell module, and therefore it is required to have more excellent weather resistance (such as light resistance or heat resistance), but since the backsheet 1 has an excellent weather resistance, it has a sufficient weather resistance for such a use.

Fig. 2 illustrates another embodiment of the backsheet of the present invention.

The backsheet 2 according to this embodiment is a laminate having a glue layer 14 and a resin film 15 further laminated on the moisture-proof layer 13 side of the backsheet 1 as shown in Fig. 1.

In the backsheet 2, the resin film 15 is laminated, whereby the moisture-proof property and the electrical insulation property are further improved as compared with the backsheet 1. The resin film 15 is not particularly limited, and the resin film of the present invention may be used, or another resin film may be used. Such another resin film may, for example, be a fluororesin film, a nylon film or a polyethylene terephthalate film, and a fluororesin film is preferred. A fluororesin in the fluororesin film may be the same as the above. The fluororesin film used as the resin film 15 may be one consisting solely of a fluororesin, or may be one containing additives in the fluororesin.

The glue layer 14 is not particularly limited so long as it is possible to adhere the moisture-proof layer 13 and the resin film 15, and it may properly be selected from known glues.

### <Solar cell module>

The solar cell module of the present invention is provided with the backsheet of the present invention.

The constitution of the solar cell module of the present invention may be the same as the constitution of a known solar cell module except that the backsheet of the present invention is used as a backsheet. As a specific example, a solar cell module comprising a transparent substrate, a filler layer having a solar cell element sealed therein and the backsheet in this order, wherein, as the above backsheet, the above-mentioned backsheet 1 or backsheet 2 is arranged so that the film surface 11 a is in contact with the air.

As the transparent substrate, a substrate commonly used for a solar cell module may be used, and for example, a glass substrate may be mentioned. The transparent substrate preferably has a transmittance at a wavelength of from 400 nm to 1,000 nm of at least 90%. The shape of the transparent substrate is not particularly limited, and may be properly selected depending on the purpose of use.

The solar cell element is an element to convert the sunlight to electric energy, and a solar cell element commonly used for a solar cell module may be used.

The filler layer to seal the solar cell element therein may be formed by a filler commonly used for a solar cell module. The filler may, for example, be EVA (ethylene/vinyl acetate copolymer).

### [Examples]

Now, the present invention will be described in detail with reference to Examples and Comparative Examples. However, the present invention is not limited to the following specific Examples.

### <Production of composite particles (B)>

### (1. Component analysis)

With respect to a commercially available titanium oxide having a cover layer containing at least aluminum oxide on the surface of titanium oxide: Ti-Pure (registered trademark) R-350, R-140 (manufactured by DuPont), RCL-69, TiONA188 (manufactured by Millennium Inorganic Chemicals) and CR470 (manufactured by Tronox), analysis was carried out in accordance with the following procedure by using a scanning type fluorescent X-ray analyzer ZSX Primus II (manufactured by Rigaku Corporation).

Using a press sheet of titanium oxide, in addition to titanium oxide (TiO₂), aluminum oxide (Al₂O₃), sodium oxide (Na₂O), silicon oxide (SiO₂), diphosphorus pentoxide (P₂O₅), zirconium oxide (ZrO₂) and zinc oxide (ZnO) were quantified.

Analysis results are shown in Table 1. Each of the numerical values in Table 1 indicates a content (mass%) of each component in each titanium oxide. "Others" are elements not measured. As elements, carbon was mainly detected. Accordingly, it was found that each titanium oxide was not a little subjected to surface treatment by e.g. an organic surface treating agent (silicone, trimethylolpropane, ester).

**[Table 1]**

| | R-350 | R104 | RCL-69 | TiONA188 | CR470 |
|---|---|---|---|---|---|
| TiO₂ | 96.7 | 97.4 | 97.6 | 97.1 | 97.1 |
| Na₂O | 0 | 0.1 | 0.1 | 0 | 0 |
| Al₂O₃ | 1.4 | 1.6 | 1.6 | 0.7 | 2.1 |
| SiO₂ | 1.7 | 0.1 | 0.3 | 0.3 | 0 |
| P₂O₅ | 0 | 0.1 | 0 | 0.1 | 0 |
| ZrO₂ | 0 | 0 | 0 | 0 | 0 |
| Others | 0.2 | 0.7 | 0.4 | 1.8 | 0.8 |

### (2. Surface treatment)

With respect to the above commercially available titanium oxide, surface treatment was carried out in the following procedure to form a surface treated layer, whereby composite particles (b1) to (b5) were obtained.

2 Parts by mass of dimethylsilicone oil (surface treating agent, tradename: SH-200, manufactured by Dow Corning Toray Co., Ltd.) per 100 parts by mass of each titanium oxide, was dispersed in isopropyl alcohol (IPA), and 100 parts by mass of titanium oxide was added thereto and mixed therewith, followed by baking at 140°C for 2 hours to obtain aimed composite particles.

The type of titanium oxide used in the production of the respective composite particles (b1) to (b5) and the contents (mass%) of the respective components to the total mass of the respective composite particles are shown in Table 2. In Table 2, DMS represents dimethylsilicone oil.

**[Table 2]**

| | (b1) | (b2) | (b3) | (b4) | (b5) |
|---|---|---|---|---|---|
| Type of titanium oxide | R-350 | R104 | RCL-69 | TiONA188 | CR470 |
| TiO₂ | 94.80 | 95.49 | 95.69 | 95.20 | 95.20 |
| Na₂O | 0 | 0.10 | 0.10 | 0 | 0 |
| Al₂O₃ | 1.37 | 1.57 | 1.57 | 0.69 | 2.06 |
| SiO₂ | 1.67 | 0.10 | 0.29 | 0.29 | 0 |
| P₂O₅ | 0 | 0.10 | 0 | 0.10 | 0 |
| ZrO₂ | 0 | 0 | 0 | 0 | 0 |
| Others | 0.20 | 0.69 | 0.39 | 1.76 | 0.78 |
| DMS | 1.96 | 1.96 | 1.96 | 1.96 | 1.96 |

### <Production of composite particles (C)>

### (1. Preparation of silica-covered zinc oxide)

In accordance with JP-A-11-256133, a silica-covered zinc oxide was prepared by the following procedure.

1 kg of commercially available zinc oxide fine particles having an average particle size of 0.02 µm were gradually added to 10,000 mL of warm water having a temperature of 60°C, and then hydrated with stirring for a little over 1 hour while keeping the temperature at 60°C to prepare a zinc hydroxide slurry. Separately, 3,508.8 g of No. 3 sodium silicate solution (concentration as calculated as SiO₂: 28.5 mass%) was diluted with water to be 12,300 mL. Further, 472.9 g of 95 mass% sulfuric acid was diluted with water to prepare 12,300 mL of dilute sulfuric acid.

While the zinc hydroxide slurry was stirred under heating to at least 80°C, the diluted sodium silicate solution and the diluted sulfuric acid solution were dropwise added thereto at the same time so that pH of a reaction fluid would be within a range of from 8 to 10. After completion of dropwise addition of both solutions, the reaction fluid was stirred for 30 minutes and then adjusted to have a pH of from 6 to 7 by dilute sulfuric acid. To this dispersion fluid, aluminum sulfate was added as a coagulant, followed by filtration, washing with water, drying, firing (500°C) and pulverization to obtain silica-covered zinc oxide containing 50 mass% of zinc oxide.

Further, silica-covered zinc oxide containing 20 mass% of zinc oxide was obtained in the same manner except that amounts of the diluted No. 3 sodium silicate solution and the diluted sulfuric acid added were changed.

Silica-covered zinc oxides thus obtained are called AZ5050 and ZA2080 respectively.

### (2. Component analysis)

Commercially available silica-covered zinc oxide: With respect to ZnO-350 SiO₂ (5) (manufactured by Ishihara Sangyo Kaisha, Ltd.), FINEX-30W-LP2 (manufactured by Sakai Chemical CO., Ltd.) and silica-covered zinc oxides AZ5050 and AZ2080 prepared as the above, component analysis is carried out by the same procedure as the above by using a scanning type fluorescent X-ray analyzer ZSX Primus II (manufactured by Rigaku Corporation), and analysis results of the ratio of silica to zinc oxide and the total amount thereof are shown in Table 3. The numerical value in Table 3 shows the content (mass%) of each component in each silica-covered zinc oxide.

At that time, aluminum and carbon were detected as other components (elements). It is considered that these elements are derived from aluminum sulfate used as a coagulant at the time of preparation of the silica-covered zinc oxide and a surface treating agent used for hydrophobization.

Further, 500°C ignition losses of the above commercially available silica-covered zinc oxides and two types of silica-covered zinc oxides prepared were measured, and all of them were found to be within 2%.

**[Table 3]**

| | ZnO-350 SiO₂ (5) | FINEX-30W-LP2 | AZ5050 | AZ2080 |
|---|---|---|---|---|
| ZnO:SiO₂ | 95:5 | 77:23 | 50:50 | 20:80 |
| Total of ZnO and SiO₂ | 97 | 94 | 96 | 96 |

### (3. Surface treatment)

Then, with respect to each of the above silica-covered zinc oxides, surface treatment was carried out by the following procedure to form a surface treated layer, and composite particles (c1) to (c4) were obtained.

3 Parts by mass of dimethylsilicone oil (surface treating agent, tradename: SH-200, manufactured by Dow Corning Toray Co., Ltd.) or 10 parts by mass of isobutyltrimethoxysilane (manufactured by Dow Corning Toray Co., Ltd.) per 100 parts by mass of the silica-coated zinc oxide, was dispersed in isopropyl alcohol (IPA), and 100 parts by mass of the silica-covered zinc oxide was added thereto and mixed therewith, followed by baking at 140°C for 2 hours to obtain aimed composite particles.

The type of the silica-covered zinc oxide used in production of each of the composite particles (c1) to (c4) and the content (mass%) of each component to the total mass of each of the composite particles are shown in Table 4. In Table 4, DMS represents dimethylsilicone oil, and IBS represents isobutyltrimethoxysilane.

**[Table 4]**

| | (c1) | (c2) | (c3) | (c4) |
|---|---|---|---|---|
| Silica-covered zinc oxide | ZnO-350 SiO₂(5) | FINEX-30W-LP2 | AZ5050 | AZ2080 |
| ZnO | 89.5 | 70.3 | 43.6 | 18.6 |
| SiO₂ | 4.7 | 21.0 | 43.6 | 74.6 |
| DMS | 2.9 | 2.9 | - | 2.9 |
| IBS | - | - | 9.1 | - |

### <Example 1>

As a resin, Fluon (registered trademark) C-88AX (ETFE, manufactured by Asahi Glass Company, Limited) was used.

100 Parts by mass of Fluon C-88AX was mixed with 9.05 parts by mass of composite particles (b1), and then the mixture was extruded from a 35 mm co-rotating twin screw extruder (TEM35: manufactured by Toshiba Machine Co., Ltd.) at a temperature of 320°C in a discharge amount of 20 kg per hour to obtain titanium oxide-containing pellets.

The titanium oxide-containing pellets were dried at 150°C for 1 hour, and then formed into a fluororesin film having a thickness of 20 µm. As the extrusion conditions, a 30 mm single screw extruder having a 450 mm T-die attached to the tip was used as a forming machine. The film discharged from the T-die was passed between a mirror surface roll kept at 150°C and a silicon embossing roll kept at 100°C while being nipped to apply corona discharge on both surfaces, to obtain a desired fluororesin film.

Corona discharge treatment was carried out in production of a backsheet for increasing an adhesive force when the fluororesin film is laminated with e.g. a PET film by using an adhesive.

The resulting fluororesin film was evaluated as follows. The results are shown in Table 5.

With respect to the fluororesin film immediately after the production, the solar reflectance (%) and the transmittance (%) at a wavelength of 360 nm as stipulated by JIS R3106 were measured by using UV-PC3300 measuring apparatus manufactured by Shimadzu Corporation. As a result, the solar reflectance (initial solar reflectance) was 61.2% and the transmittance (initial transmittance) at a wavelength of 360 nm was less than 0.01%.

Further, the resulting fluororesin film was punched in a shape (dumbbell specimen) as defined in ASTM D638 TYPE V, and the tensile breaking strength was measured to obtain an average breaking strength (initial breaking strength) in the lengthwise direction and the transverse direction.

Separately, the resulting fluororesin film was cut into a size of 7 cm x 15 cm to prepare an evaluation sample. This evaluation sample was charged in an accelerated weather resistance test apparatus (manufactured by Suga Test Instruments Co., Ltd., Sunshine 300), and exposed for 10,000 hours. As the exposure condition, the black panel temperature was 63°C.

With respect to the evaluation sample after the exposure for 10,000 hours, the solar reflectance (solar reflectance after the test) was measured in the same manner as the above. Further, the evaluation sample was punched in a shape (dumbbell specimen) as defined in ASTM D638 TYPE V, and the tensile breaking strength was measured to obtain an average breaking strength (breaking strength after the test) in the lengthwise direction and the transverse direction.

From the above results, the rate of change (change of solar reflectance after test, %) of the solar reflectance after the test to the initial solar reflectance and the proportion of the breaking strength after the test to the initial breaking strength (retention of breaking strength after test, %) of the breaking strength after the test to the initial breaking strength were obtained.

### <Example 2>

100 Parts by mass of Fluon C-88AX, 9.05 parts by mass of the composite particles (b1) and 0.328 part by mass of commercially available zinc oxide fine particles (FINEX-30S-LP2, manufactured by Sakai Chemical Co., Ltd.) having the surface hydrophobized were blended, and then the mixture was extruded from a 35 mm co-rotating twin screw extruder (TEM35: manufactured by Toshiba Machine Co., Ltd.) at a temperature of 320°C in a discharge amount of 20 kg per hour to obtain titanium oxide-containing pellets. Using the resulting titanium oxide-containing pellets, an aimed fluororesin film was obtained in the same manner as in Example 1.

The resulting fluororesin film was evaluated in the same manner as in Example 1. Results are shown in Table 5.

### <Example 3>

100 Parts by mass of Fluon C-88AX, 9.05 parts by mass of the composite particles (b1) and 0.328 part by mass of a commercially available silica (AEROSIL (registered trademark) R972, manufactured by Nippon Aerosil Co., Ltd., a hydrophobized fumed silica) were blended, and then the mixture was extruded from a 35 mm co-rotating twin screw extruder (TEM35: manufactured by Toshiba Machine Co., Ltd.) at a temperature of 320°C in a discharge amount of 20 kg per hour to obtain titanium oxide-containing pellets.

Using the resulting titanium oxide-containing pellets, an aimed fluororesin film was obtained in the same manner as in Example 1.

The resulting fluororesin film was evaluated in the same manner as in Example 1. Results are shown in Table 5.

### <Examples 4 to 13>

100 Parts by mass of Fluon C-88AX, titanium oxide composite particles in an amount (part by mass) shown in Table 5 and zinc oxide composite particles in an amount (part by mass) shown in Table 5 were blended, and then the mixture was extruded from a 35 mm co-rotating twin screw extruder (TEM35: manufactured by Toshiba Machine Co., Ltd.) at a temperature of 320°C in a discharge amount of 20 kg per hour to obtain titanium oxide-containing pellets. Using the resulting titanium oxide-containing pellets, an aimed fluororesin film was obtained in the same manner as in Example 1.

The resulting fluororesin film was evaluated in the same manner as in Example 1. Results are shown in Table 5.

### <Example 14>

A fluororesin film was obtained in the same manner as in Example 1 except that 11.48 parts by mass of the composite particles (b2) were used instead of 9.05 parts by mass of the composite particles (b1).

The resulting fluororesin film was evaluated in the same manner as in Example 1. Results are shown in Table 6.

### <Examples 15 to 26>

100 Parts by mass of Fluon C-88AX, titanium oxide composite particles in an amount (part by mass) shown in Table 6 and zinc oxide composite particles in an amount (part by mass) shown in Table 6 were blended, and then the mixture was extruded from a 35 mm co-rotating twin screw extruder (TEM35: manufactured by Toshiba Machine Co., Ltd.) at a temperature of 320°C in a discharge amount of 20 kg per hour to obtain titanium oxide-containing pellets. Using the resulting titanium oxide-containing pellets, an aimed fluororesin film was obtained in the same manner as in Example 1.

The resulting fluororesin film was evaluated in the same manner as in Example 1. Results are shown in Table 6.

**[Table 5]**

| | | | Ex. 1 | Ex. 2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 |
|---|---|---|---|---|---|---|---|---|---|---|---|---|---|---|---|
| | Resin (A) | ETFE | 100 | 100 | 100 | 100 | 100 | 100 | 100 | 100 | 100 | 100 | 100 | 100 | 100 |
| | Titanium oxide composite particles | (b1) | | | | | | | | | | | | | |
| | | (b2) | | | | | | | | | | | | | |
| Blend amount (part by mass) | | (b3) | 9.05 | 9.05 | 9.05 | 9.05 | 9.05 | 9.05 | 9.05 | 9.05 | 9.05 | 9.05 | 9.05 | 8.3 | 9.05 |
| | | (b4) | | | | | | | | | | | | | |
| | | (b5) | | | | | | | | | | | | | |
| | Zinc oxide composite particles | (c1) | | | | 0.328 | | | | | | | | | |
| | | (c2) | | | | | | | | | 0.0764 | 0.142 | 0.219 | 0.328 | |
| | | (c3) | | | | | 0.109 | 0.163 | 0.219 | 0.328 | | | | | |
| | | (c4) | | | | | | | | | | | | | 0.219 |
| | Zinc oxide | FINEX-30 | | 0.328 | | | | | | | | | | | |
| | Silica | AEROSOL R972 | | | 0.328 | | | | | | | | | | |
| Al₂O₃ in titanium oxide composite particles (%) | | | 1.57 | 1.57 | 1.57 | 1.57 | 1.57 | 1.57 | 1.57 | 1.57 | 1.57 | 1.57 | 1.57 | 1.57 | 1.57 |
| TiO₂ in titanium oxide composite particles (%) | | | 95.69 | 95.69 | 95.69 | 95.69 | 95.69 | 95.69 | 95.69 | 95.69 | 95.69 | 95.69 | 95.69 | 95.69 | 95.69 |
| ZnO/SiO₂ in zinc oxide composite particles | | | | | | 95/5 | 50/50 | 50/50 | 50/50 | 50/50 | 77/23 | 77/23 | 77/23 | 77/23 | 20/80 |
| ZnO+SiO₂ in zinc oxide composite particles (%) | | | | | | 94.1 | 87.3 | 87.3 | 87.3 | 87.3 | 94.1 | 94.1 | 94.1 | 94.1 | 94.1 |
| | Initial transmittance (%) (at 360 nm) | | <0.01 | <0.01 | <0.01 | <0.01 | <0.01 | <0.01 | <0.01 | <0.01 | <0.01 | <0.01 | <0.01 | <0.01 | <0.01 |
| Evaluation | Initial solar transmittance (%) | | 61.2 | 61.8 | 61.8 | 62.5 | 60.2 | 59.3 | 59.2 | 58.5 | 58.5 | 59.9 | 59.7 | 58.2 | 59.3 |
| | Change of solar reflectance after test (%) | | 1.1 | 0.8 | 0.9 | 1.5 | 0.3 | 0.2 | 0.1 | -0.1 | -1.1 | -1.1 | -0.7 | -0.3 | 1.2 |
| | Retention of breaking strength after test (%) | | 76 | 76 | 74 | 72 | 84 | 86 | 86 | 90 | 86 | 88 | 88 | 86 | 77 |

**[Table 6]**

| | | | Ex. 14 | Ex. 15 | Ex. 16 | Ex. 17 | Ex. 18 | Ex. 19 | Ex. 20 | Ex. 21 | Ex. 22 | Ex.23 | Ex. 24 | Ex. 25 | Ex. 26 |
|---|---|---|---|---|---|---|---|---|---|---|---|---|---|---|---|
| | Resin (A) | ETFE | 100 | 100 | 100 | 100 | 100 | 100 | 100 | 100 | 100 | 100 | 100 | 100 | 100 |
| | Titanium oxide composite particles | (b1) | | | | | 11.48 | | | | | | | | |
| Blend amount (part by mass) | | (b2) | 11.48 | 11.48 | 11.48 | 11.48 | | | | | | | | | |
| | | (b3) | | | | | | | | | | | | | |
| | | (b4) | | | | | | 9.05 | 9.05 | 9.05 | 9.05 | | | | |
| | | (b5) | | | | | | | | | | 9.05 | 9.05 | 9.05 | 9.05 |
| | Zinc oxide composite particles | (c1) | | | | | | | | | | | | | |
| | | (c2) | | | | | 0.336 | | 0.109 | 0.219 | 0.328 | | 0.109 | 0.219 | 0.328 |
| | | (c3) | | 0.045 | 0.223 | 0.448 | | | | | | | | | |
| | | (c4) | | | | | | | | | | | | | |
| Al₂O₃ in titanium oxide composite particles (%) | | | 1.57 | 1.57 | 1.57 | 1.57 | 1.37 | 0.69 | 0.69 | 0.69 | 0.69 | 2.06 | 2.06 | 2.06 | 2.06 |
| TriO₂ in titanium oxide composite particles (%) | | | 95.49 | 95.49 | 95.49 | 95.49 | 94.8 | 95.2 | 95.2 | 95.2 | 95.2 | 95.2 | 95.2 | 95.2 | 95.2 |
| ZnO/SiO₂ in zinc oxide composite particles | | | | 50/50 | 50/50 | 50/50 | 77/23 | | 77/23 | 77/23 | 77/23 | | 77/23 | 77/23 | 77/23 |
| ZnO+SiO₂ in zinc oxide composite particles (%) | | | | 87.3 | 87.3 | 87.3 | 94.1 | | 94.1 | 94.1 | 94.1 | | 94.1 | 94.1 | 94.1 |
| Evaluation | Initial transmittance (%) (at 360 nm) | | <0.01 | <0.01 | <0.01 | <0.01 | 0.05 | <0.01 | <0.01 | <0.01 | <0.01 | <0.01 | <0.01 | <0.01 | <0.01 |
| | Initial solar transmittance (%) | | 64.0 | 64.4 | 63.7 | 63.4 | 62.7 | 60.1 | 60.7 | 58.4 | 57.8 | 60.0 | 60.5 | 59.8 | 58.8 |
| | Change of solar reflectance after test (%) | | 2.2 | 3.1 | -0.7 | -0.1 | -0.2 | 3.5 | -0.1 | -0.2 | -0.1 | 2.4 | -0.1 | 0.1 | -0.1 |
| | Retention of breaking strength after test (%) | | 56 | 60 | 84 | 84 | 86 | 60 | 83 | 86 | 88 | 78 | 85 | 88 | 88 |

Among Examples 1 to 26, Examples 5 to 12, 16, 17, 20 to 22 and 24 to 26 are Examples of the present invention, and Examples 1 to 4, 13 to 15, 18, 19 and 23 are Comparative Examples.

With respect to the optical properties, an outermost film of a backsheet for a solar cell module is required to have an ultraviolet transmittance at 360 nm being at most 0.03% when protection of e.g. an adhesive is considered. Further, the higher the solar reflectance of a backsheet is, the less the module temperature of a solar cell increases, whereby the power generation efficiency is less deteriorated in summer, and therefore a solar reflectance of at least 50% is required.

All of the fluororesin films in Examples 5 to 12, 16, 17, 20 to 22 and 24 to 26 have an initial transmittance of at most 0.03% and an initial solar reflectance of at least 50%, whereby an initial performance required to the backsheet was satisfied. Further, even though titanium oxide was contained in such an amount as to develop sufficient ultraviolet shielding performance, change in the solar reflectance after the accelerated weather resistance test was small, and further the retention of the breaking strength was high, whereby the film had an excellent weather resistance.

Both of the small change in solar reflectance after the accelerated weather test and the high retention of breaking strength mean that the catalytic activity of titanium oxide is highly suppressed. For example, in a case where the catalytic activity is not suppressed, titanium oxide moves toward a site where light or water is applied in a film during the test, whereby the film is further whitened (whitening), and therefore the solar reflectance is increased to increase the change in solar reflectance. Further, ETFE is decomposed by the action of titanium oxide, whereby the retention of breaking strength deteriorates.

Further, in measurement of the solar reflectance, the parallelism between a film and a light source affects a measurement value of the reflectance, and in the case of a thin and soft film having a thickness of about 20 µm, a slight curl tends to occur and thereby to cause an error of approximately ±0.5%. Further, the accelerated weather resistance test is a carbon arc type test, and therefore samples tend to be contaminated by combustion of carbon during the exposure test even though water is sprayed on the samples. Accordingly, there is a case where the solar reflectance decreases by approximately 1.0%. Accordingly, in a case where the catalytic activity is discussed on the basis of the rate of change in solar resistance before and after the weather resistant test, no development of catalytic activity at all indicates a change in solar reflectance of increase up to 0.5% or reduction to 1.5% after the accelerated weather resistance test. Therefore, when the change in reflectance is within a range of from -1.5 to 0.5%, the catalytic activity is considered to be suppressed.

Further, a 20 µm-thick ETFE film containing no titanium oxide at all has a retention of the breaking strength of 90%, and when the retention is at least 80%, such a film can be determined as a highly reliable film having suppressed catalytic activity.

On the other hand, in the fluororesin films in Examples 1, 14, 19 and 23 where only titanium oxide composite particles were added, the solar reflectance was increased by at least 1.1 % after the accelerated weather resistance test, and whitening was observed in outer appearance. Further, the retention of the breaking strength was less than 80%.

In Examples 2 where zinc oxide fine particles were added and Example 3 where silica was added, the solar reflectance was increased by from 0.8 to 0.9% after the accelerated weather resistance test. Further, the retention of the breaking strength was less than 80%.

In Example 4 where composite particles (c1) having ZnO/SiO₂ of 95/5 were added as zinc oxide composite particles, the solar reflectance after the accelerated weather resistance test was increased by 1.5%, and the whitening in outer appearance was observed. Further, the retention of the breaking strength was less than 80%.

In Example 18 where the composite particles (b1) having a titanium oxide content of 94.8 mass% were blended as titanium oxide composite particles, the ultraviolet transmittance at 360 nm exceeded 0.03%.

### INDUSTRIAL APPLICABILITY

According to the present invention, it is possible to provide a resin film showing excellent ultraviolet shielding performance even when the thickness of the film is at most 20 µm, further having excellent weather resistance and being hardly changeable in optical properties and mechanical properties over a long period of time, and such a resin film is useful especially as a backsheet for a solar cell module.

### REFERENCE SYMBOLS

- 1: Backsheet
- 2: Backsheet
- 11: Outermost film
- 12: Adhesive layer
- 13: Moisture-proof layer
- 14: Glue layer
- 15: Resin film

## Claims

1. A resin film comprising a resin (A) containing a fluororesin; and, contained in the resin (A), composite particles (B) each having a cover layer containing at least aluminum oxide on the surface of a titanium oxide particle, and composite particles (C) each having a cover layer containing at least silicon oxide on the surface of a zinc oxide particle, wherein
in the resin (A), the proportion of the fluororesin is at least 50 mass%,
in the composite particles (B), the proportion of aluminum oxide is from 0.6 to 2.5 mass%, and the proportion of titanium oxide is at least 95 mass%,
the content of the composite particles (B) is from 2 to 15 mass% to the resin (A), in the composite particles (C), the mass ratio (ZnO/SiO₂) of zinc oxide to silicon oxide is from 50/50 to 85/15, and the total amount of zinc oxide and silicon oxide is at least 80 mass%, and
the content of the composite particles (C) to the fluororesin is from 0.05 to 0.5 mass%.

2. The resin film according to Claim 1, wherein the fluororesin is an ethylene/tetrafluoroethylene copolymer.

3. The resin film according to Claim 1 or 2, wherein the resin (A) is an ethylene/tetrafluoroethylene copolymer.

4. The resin film according to any one of Claims 1 to 3, which is used for a backsheet for a solar cell module.

5. A backsheet for a solar cell module, which is provided with the resin film as defined in any one of Claims 1 to 3.

6. A solar cell module provided with the backsheet as defined in Claim 5.

## Patentansprüche

1. Harzfilm, umfassend ein Harz (A), enthaltend ein Fluorharz; und, enthalten in dem Harz (A), Verbundteilchen (B) mit jeweils einer Deckschicht, enthaltend mindestens Aluminiumoxid auf der Oberfläche eines Titanoxidteilchens, und Verbundteilchen (C) mit jeweils einer Deckschicht, enthaltend mindestens Siliziumoxid auf der Oberfläche eines Zinkoxidteilchens, wobei in dem Harz (A) der Anteil des Fluorharzes mindestens 50 Massen-% beträgt, in den Verbundteilchen (B) der Anteil an Aluminiumoxid von 0,6 bis 2,5 Massen-% beträgt und der Anteil an Titandioxid mindestens 95 Massen-% beträgt,
der Gehalt der Verbundteilchen (B) von 2 bis 15 Massen-% mit Bezug auf das Harz (A) beträgt,
in den Verbundteilchen (C) das Massenverhältnis (ZnO/SiO₂) von Zinkoxid zu Siliziumoxid von 50/50 bis 85/15 beträgt und die Gesamtmenge an Zinkoxid und Siliziumoxid mindestens 80 Massen-% beträgt und
der Gehalt der Verbundteilchen (C) mit Bezug auf das Fluorharz von 0,05 bis 0,5 Massen-% beträgt.

2. Harzfilm nach Anspruch 1, wobei das Fluorharz ein Ethylen/Tetrafluorethylen-Copolymer ist.

3. Harzfilm nach Anspruch 1 oder 2, wobei das Harz (A) ein Ethylen/Tetrafluorethylen-Copolymer ist.

4. Harzfilm nach einem der Ansprüche 1 bis 3, der für eine Rückseitenfolie eines Solarzellenmoduls verwendet wird.

5. Rückseitenfolie eines Solarzellenmoduls, welche mit dem Harzfilm nach einem der Ansprüche 1 bis 3 versehen ist.

6. Solarzellenmodul, versehen mit der Rückseitenfolie nach Anspruch 5.

## Revendications

1. Film de résine comprenant une résine (A) contenant une résine fluorée ; et, contenues dans la résine (A), des particules composites (B) présentant chacune une couche de revêtement contenant au moins de l'oxyde d'aluminium sur la surface d'une particule d'oxyde de titane, et des particules composites (C) présentant chacune une couche de revêtement contenant au moins de l'oxyde de silicium sur la surface d'une particule d'oxyde de zinc, dans lequel
dans la résine (A), la proportion de la résine fluorée est d'au moins 50 % en masse,
dans les particules composites (B), la proportion d'oxyde d'aluminium est de 0,6 à 2,5 % en masse, et la proportion d'oxyde de titane est d'au moins 95 % en masse,
la teneur en particules composites (B) rapportée à la résine (A) est de 2 à 15 % en masse,
dans les particules composites (C), le rapport en masse (ZnO/SiO₂) de l'oxyde de zinc sur l'oxyde de silicium est de 50/50 à 85/15, et la quantité totale d'oxyde de zinc et d'oxyde de silicium est d'au moins 80 % en masse, et
la teneur en particules composites (C) rapportée à la résine fluorée est de 0,05 à 0,5 % en masse.

2. Film de résine selon la revendication 1, dans lequel la résine fluorée est un copolymère d'éthylène/ tétrafluoroéthylène.

3. Film de résine selon la revendication 1 ou 2, dans lequel la résine (A) est un copolymère d'éthylène/ tétrafluoroéthylène.

4. Film de résine selon l'une quelconque des revendications 1 à 3, qui est utilisé pour une feuille d'envers destinée à un module de cellule solaire.

5. Feuille d'envers pour un module de cellule solaire, qui est dotée du film de résine tel que défini dans l'une quelconque des revendications 1 à 3.

6. Module de cellule solaire doté de la feuille d'envers telle que définie dans la revendication 5.
